# EUROPÄISCHE PATENTSCHRIFT

(11) **EP 0 809 305 B1**
(45) Veröffentlichungstag und Bekanntmachung des Hinweises auf die Patenterteilung: **30.01.2002**
(21) Anmeldenummer: 97108309.2
(22) Anmeldetag: 22.05.1997
(51) Int. Cl.: H01L 39/14

(54) **Bandförmiger Hoch-Tc-Multi-Filamentsupraleiter und Verfahren zu dessen Herstellung**
Tape-shaped high Tc multifilament superconductor and method of manufacturing the same
Supraconducteur à haute température multibrins en forme de bande et procédé de fabrication

(30) Priorität: 24.05.1996 DE 19621068
(43) Veröffentlichungstag der Anmeldung: 26.11.1997
(73) Patentinhaber: SIEMENS AKTIENGESELLSCHAFT, 80333 München (DE)
(72) Erfinder: Ries, Günter, Dr., 91056 Erlangen (DE)
(74) Vertreter: Neunert, Peter Andreas

(56) Entgegenhaltungen:
- EP-A- 0 576 363
- EP-A- 0 638 942
- DE-A- 2 626 384

## Beschreibung

Die Erfindung bezieht sich auf einen bandförmigen Multifilamentsupraleiter mit einer Matrix aus normalleitendem Matrixmaterial, das eine vorbestimmte elektrische Leitfähigkeit bei der Betriebstemperatur des Multifilamentsupraleiters besitzt, und mit mehreren in das Matrixmaterial eingebetteten supraleitenden Filamenten, wobei die Filamente jeweils ein Supraleitermaterial mit einer metalloxidischen Hoch-T_{c}-Phase aufweisen und in der Matrix um die Achse des bandförmigen Multifilamentsupraleiters verdrillt angeordnet sind. Die Erfindung betrifft ferner ein Verfahren zur Herstellung eines solchen Multifilamentsupraleiters. Ein entsprechender Supraleiter und ein Verfahren zu dessen Herstellung sind aus "IEEE Transactions on Applied Superconductivity", Vol. 5, No. 2, Juni 1995, Seiten 1145 bis 1149 zu entnehmen.

Aus der DE 2626384 ist beispielsweise ein bandförmiger Supraleiter mit mehreren aus Supraleitermaterial und bei der Betriebstemperatur des Supraleitermaterials elektrisch normalleitendem Material zusammengestzten Leiteradern (Filamenten) bekannt, die um ein Band aus normalleitendem Material hoher Zugfestigkeit verseilt sind.

Weiterhin sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und eine LN₂-Kühltechnik erlauben. Unter solche Metalloxidverbindungen fallen insbesondere Cuprate von Stoffsystemen der Typen Y-Ba-Cu-O oder Bi-Sr-Ca-Cu-O oder Bi(Pb)-Sr-Ca-Cu-O. Innerhalb einzelner Stoffsysteme können mehrere supraleitende Hoch-T_{c}-Phasen auftreten, die sich durch die Anzahl der Kupfer-Sauerstoff-Netzebenen bzw. - Schichten innerhalb der kristallinen Einheitszelle unterscheiden und die verschiedene Sprungtemperaturen T_{c} aufweisen.

Mit den bekannten HTS-Materialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser Technik wird auch zur Herstellung von Leitern aus HTS-Material in eine rohrförmige Umhüllung bzw. in eine Matrix aus einem normalleitenden Material, insbesondere aus Ag oder einer Ag-Legierung, Pulver aus einem Vorprodukt des HTS-Materials eingebracht, das im allgemeinen noch nicht oder nur zu einem geringen Teil die gewünschte supraleitende Hoch-T_{c}-Phase enthält. Der so zu erhaltende Aufbau wird anschließend mittels Verformungsbehandlungen, die gegebenenfalls durch mindestens eine Wärmebehandlung bei erhöhter Temperatur unterbrochen sein können, auf die gewünschte Enddimension gebracht. Danach wird das so erhaltene draht- oder bandförmige Leitervorprodukt zur Einstellung oder Optimierung seiner supraleitenden Eigenschaften bzw. zur Ausbildung der gewünschten Hoch-T_{c}-Phase mindestens einer Glühbehandlung unterzogen. Diese Glühbehandlung wird wenigstens teilweise in einer sauerstoffhaltigen Atmosphäre, z.B. an Luft, bei einer Temperatur üblicherweise zwischen 600°C und 950°C durchgeführt (vgl. z.B. auch "Supercond. Sci. Technol.", Vol. 4, 1991, Seiten 165 bis 171).

Bündelt man in an sich bekannter Weise mehrere entsprechende band- oder drahtförmige Hoch-T_{c}-Supraleiter oder deren Leitervorprodukte, so kann man auch Leiter mit mehreren supraleitenden Filamenten, sogenannte Mehrkern- oder Multifilamentleiter, erhalten (vgl. auch "IEEE Transactions on Applied Superconductivity", Vol. 5, No. 2, Juni 1995, Seiten 1259 bis 1261). Für AC-Anwendungen muß das Bündel von einzelnen Filamenten um die gemeinsame Leiterachse verdrillt (getwistet) werden.

In entsprechenden Multifilamentsupraleitern entstehen bei einem angelegten Wechselfeld AC-Verluste. Neben den Hystereseverlusten im Supraleitermaterial selbst treten insbesondere bei höheren Frequenzen Joule'sche Verluste auf infolge induzierter Spannungen zwischen den einzelnen supraleitenden Filamenten, welche Querströme durch die normalleitende Metallmatrix fließen lassen. Die Fließrichtung dieser Matrixströme ist senkrecht zur Achse des bandförmigen Multifilamentsupraleiters und parallel zum angelegten Magnetfeld. Die entsprechenden Verluste sind von den metallischen Supraleitern wie NbTi her bekannt (vgl. z.B. "IEEE Trans. Magn.", Vol. MAG-13, No. 1, Januar 1977, Seiten 524 bis 529). Maßnahmen zur Verringerung dieser Matrixverluste sind eine möglichst kurze Twistlänge und die Verwendung eines Matrixmaterials mit hohem spezifischen elektrischen Widerstand wie z.B. einer Kupfer-Nickel-Legierung oder resistive Barrieren zwischen den einzelnen Filamenten.
In bandförmigen, verdrillten Flachleitern mit vielen Filamenten sind diese Verluste besonders groß im Fall einer Wechselfeldkomponente dB/dt senkrecht zur Flachseite des Bandes. Hier ist die senkrecht zum Feld aufgespannte Fläche des Bündels supraleitender Filamente und der zwischen diesen Filamenten auftretende Magnetfluß durch die Breite des Leiters gegeben. Bei Wechselfeld wird somit die zwischen den Filamenten induzierte Spannung erheblich. Auf der anderen Seite ist hier der Strompfad und der die Matrixströme bestimmende Matrixquerwiderstand wegen der verhältnismäßig geringen Beabstandung der Filamente besonders klein. Als Folge nehmen die Verluste in der bandförmigen Metallmatrix gegenüber einem runden Leiter um das Quadrat des sogenannten Aspektverhältnisses [= (Breite/Dicke)²] zu. In Anwendungen mit derartiger Feldbeanspruchung, z.B. in Magneten oder bei Hochstromsupraleitern, ist dadurch im allgemeinen nur noch ein Betrieb mit Gleichstrom oder sehr niedriger Frequenz wirtschaftlich sinnvoll.

Dieses Problem stellt sich insbesondere bei Verwendung von Multifilamentleitern mit HTS-Material auf Basis von Cupraten der Grundtypen YBa₂Cu₃Oₓ oder Bi₂Sr₂Ca₂Cu₃O_{y}. Ein wesentlicher Schritt bei der Herstellung solcher Leiter ist ein Flachwalzen des Leiters zu einer Bandform, mit dem die für eine hohe Stromtragfähigkeit notwendige Textur, d.h. weitgehend parallele Ausrichtung der Kristallebenen der supraleitenden Phase, erzielt wird. Das Ergebnis ist ein Flachleiter mit einem Breiten-zu-Dicken-Verhältnis von beispielsweise 10 oder mehr.

Die Wechselfeldverluste fallen auf tiefem Temperaturniveau an und müssen mit erheblichem Energieaufwand für eine Kältemaschine abgeführt werden. Insbesondere in elektrischen Einrichtungen der Energietechnik wie z.B. Transformatoren, Motoren oder Generatoren, bei denen eine nicht vernachlässigbare 50- oder 60-Hz-Feldkomponente senkrecht zum Leiterband auftritt, sind diese Verluste mit den heute bekannten HTS-Bandleitern noch zu groß. Diese Leiter können deshalb im allgemeinen noch nicht mit wirtschaftlichen Vorteilen gegenüber konventionellen Lösungen eingesetzt werden.

Aufgabe der vorliegenden Erfindung ist es deshalb, den verdrillten Hoch-T_{c}-Multifilamentsupraleiter mit den eingangs genannten Merkmalen dahingehend auszugestalten, daß seine Wechselfeldverluste gegenüber bekannten HTS-Multifilamentleitern reduziert sind.

Diese Aufgabe wird erfindungsgemäß dadurch gelöst, daß die Matrix einen zentralen Kernbereich aus einem Kernmaterial aus einem Kernmaterial mit einer gegenüber der elektrischen Leitfähigkeit des Matrixmaterials um mindestens eine Größenordnung geringeren elektrischen Leitfähigkeit aufweist.

Die mit dieser Ausgestaltung des HTS-Multifilament-Bandleiters verbundenen Vorteile sind insbesondere darin zu sehen, daß sich die Wechselfeldverluste bei Feldkomponenten senkrecht zum Band wirksam reduzieren lassen. Die quer durch die Matrix in dem normalleitenden Matrixmaterial fließenden Ströme werden nämlich durch den verhältnismäßig schlecht leitenden zentralen Leiterkern unterbrochen bzw. umgelenkt. Dadurch verlängert sich der Weg des wechselfeldinduzierten Stromflusses, d.h. der stromführende Querschnitt des Leiters verringert sich entsprechend. Infolge des so erhöhten Matrixquerwiderstandes werden die Stromdichte in der Metallmatrix und damit die Verluste bei einer Wechselfeldkomponente senkrecht zum Leiterband verkleinert.

Vorteilhaft läßt sich der Multifilamentsupraleiter nach der Erfindung dadurch herstellen, daß zunächst ein Strangpreßbolzen ausgebildet wird, der eine zentrale Bohrung, die mit dem Kernmaterial gefüllt ist, sowie einen diese Bohrung umgebenden Strangpreßkörper aus dem Matrixmaterial mit Bohrungen enthält, die mit einem Vorprodukt des Supraleitermaterials gefüllt sind, und daß dann dieser Strangpreßbolzen mehreren Verformungsschritten und Temperaturbehandlungen unterzogen wird, wobei mittels mindestens eines Walzschrittes die Bandform des Endproduktes des Multifilamentsupraleiters erzeugt wird. Ein derartiges Verfahren ist besonders geeignet, auf verhältnismäßig einfache Weise einen Multifilamentsupraleiter aus dem Verbund seiner verschiedenen Materialien herzustellen.

Vorteilhafte Ausgestaltungen des erfindungsgemäßen HTS-Multifilamentleiters gehen aus den abhängigen Ansprüchen hervor.

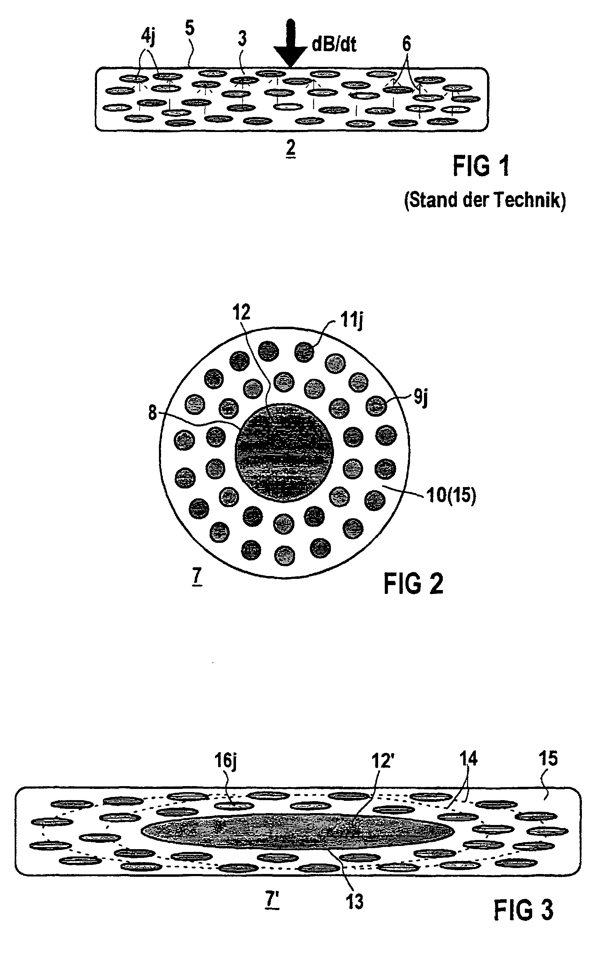

Die Erfindung wird nachfolgend noch weiter erläutert, wobei auf die Zeichnung Bezug genommen wird. Dabei zeigen jeweils schematisch
- deren Figur 1: einen bekannten HTS-Multifilamentleiter,
- deren Figur 2: einen Rohleiter eines erfindungsgemäßen HTS-Multifilamentleiters
und
- deren Figur 3: ein aus diesem Rohleiter hergestelltes Endprodukt des HTS-Multifilamentleiters.

Dabei sind in den Figuren sich entsprechende Teile mit denselben Bezugszeichen versehen.

Figur 1 zeigt einen Querschnitt durch einen bekannten Hoch-T_{c}-Multifilamentsupraleiter 2, der in einer Matrix 3 aus einem Ag-Material eine Vielzahl von Filamenten (Leiteradern) 4j aus einem Hoch-T_{c}-Supraleitermaterial aufweist. Dieser Leiter 2 soll in einem Wechselfeld mit einer ausgeprägten Komponente dB/dt, die senkrecht zur Flachseite 5 des Leiters 2 gerichtet und in der Figur durch eine gepfeilte Linie angedeutet ist, betrieben werden können. Dann werden in der Matrix 3 zwischen den einzelnen Filamenten 4j unerwünschte Querströme induziert, die durch gestrichelte, mit 6 bezeichnete Linien veranschaulicht sind. Diese Querströme sind vorteilhaft bei einem erfindungsgemäßen Hoch-T_{c}-Multifilamentsupraleiter reduziert.

Zur Herstellung eines entsprechenden Multifilamentsupraleiters sind alle an sich bekannten Verfahren geeignet, die die Ausbildung eines zentralen Kernbereiches aus einem anderen Material als dem der Matrix des Leiters gestatten. Besonders geeignet ist das nachfolgend skizzierte Verfahren, das auf dem aus der DE 44 17 426 A bekannten Verfahren basiert. Dem-gemäß wird ein in Figur 2 im Querschnitt veranschaulichte Strangpreßbolzen oder Butzen 7 mit einer zentralen, verhältnismäßig großen Bohrung 8 für einen besonderen Leiterkern sowie mit einer der gewünschten Anzahl an supraleitenden Filamenten entsprechenden Zahl von Bohrungen 9j versehen. Die Bohrungen 9j liegen dabei zweckmäßig auf konzentrischen Linien um die zentrale Bohrung 8. Mit dem so entstandenen, hohlzylinderförmigen Strangpreßkörper 10 wird das Matrix-Material 15 für die Filamente zur Verfügung gestellt. Das Matrixmaterial soll bei der zur Bildung des HTS-Materials nötigen Wärmebehandlung weder mit diesem noch mit dem Sauerstoff der Reaktionsatmosphäre chemisch reagieren. Es kommt deshalb als Matrixmaterial vorzugsweise ein Ag-Material aus reinem Ag oder einer Ag-Legierung in Frage. So ist z.B. reines Ag z.B. in Form von kaltverfestigtem Silber oder rekristallisiertem Silber verwendbar. Auch kann pulvermetallurgisch hergestelltes Silber vorgesehen werden. Daneben ist auch dispersionsgehärtetes Silber geeignet. Ferner kann auch ein Matrixmaterial 15 mit einem erhöhten elektrischen Widerstand durch Legieren des Ag mit Metallen wie Palladium, Aluminium, Kupfer, Magnesium oder anderen widerstandserhöhenden Zusätzen eingesetzt werden. Entsprechende Legierungen können bei der Betriebstemperatur von beispielsweise 77 K eine elektrische Leitfähigkeit κ in der Größenordnung von höchstens
[1 µΩ·cm]⁻¹ haben. Damit lassen sich die wechselstrombedingten Matrixverluste weiter reduzieren, bzw. erweitert sich der Bereich des wirtschaftlichen Einsatzes des erfindungsgemäßen Multifilamentsupraleiters zu höheren Frequenzen.
In die Bohrungen 9j des hohlzylinderförmigen Strangpreßkörpers 10 wird jeweils ein sogenanntes Vorprodukt 11j des Hoch-T_{c}-Supraleitermaterials (HTS-Materials) eingebracht, das z.B. pulverförmig ist und im allgemeinen noch nicht die gewünschte supraleitende Hoch-T_{c}-Phase enthält. Demgegenüber soll die zentrale Bohrung 8 mit einem Kernmaterial 12 gefüllt werden, das eine gegenüber dem Matrixmaterial vergleichsweise geringere elektrische Leitfähigkeit κ besitzt. Dabei soll die Leitfähigkeit des Kernmaterials 12 mindestens eine Größenordnung kleiner sein als die des Matrixmaterials 15. Insbesondere kommen für den Leiterkern elektrisch isolierende Materialien in Frage. Z.B. ist ein oxidisches Pulver wie ZrO₂, SiO₂, CuO₂, Al₂O₃ oder ein HTS-Supraleitermaterial geeignet, das durch eine falsche Stöchiometrie gegenüber der Hoch-T_{c}-Phase, z.B, aufgrund eines Unterschusses an Kupfer oder Wismut, oder durch Beimengungen, z.B. von Zink oder Aluminium, absichtlich bei der Betriebstemperatur normalleitend gemacht worden ist.

Der so entstandene, in Figur 2 dargestellte Strangpreßbolzen 7 wird nun in an sich bekannter Weise durch Strangpressen und Drahtziehen zu einem Rohleiter mit zumindest annähernd kreisförmigem Querschnitt unter Verdichtung zumindest des Materials der Vorprodukte 11j verformt. In diesem runden Rohleiter wird anschließend durch Verdrillen ein Twist mit vorgegebener Verdrillänge erzeugt. Durch weitere Zieh- und Walzschritte und eingeschaltete Reaktionsglühungen, die insbesondere in einer sauerstoffhaltigen Atmosphäre durchgeführt werden können, wird dann ein bandförmiges Endprodukt eines verdrillten Multifilamentsupraleiters erhalten, das dann in Figur 3 im Querschnitt dargestellt ist.

Wie aus dieser Figur 3 hervorgeht, weist das bandförmige Endprodukt des erfindungsgemäßen Multifilamentsupraleiters 7' aufgrund des Walzens des Rohleiters einen zentralen Leiterkern 12' in der Mittelebene auf, der nunmehr einen etwa ovalen Querschnitt besitzt. Der somit gegenüber dem Kern 12 des Rohleiters 7 deutlich verbreiterte und dabei abgeflachte Leiterkern 12' bewirkt, daß über seinen Bereich (Querschnitt) 13 praktisch keine wechselstrombedingten Matrixströme mehr fließen können, sondern diese Ströme in der in der Figur durch gestrichelte Linien 14 angedeuteten Weise um den Leiterkern 12 herum in dem mit 15 bezeichneten Matrixmaterial umgelenkt werden. Damit ist eine entsprechende Reduzierung der Matrixströme und somit der Verluste bei einer Wechselfeldkomponente senkrecht zum Leiterband verbunden. In der Figur sind die aus den Vorprodukten 11j des HTS-Materials (vgl. Figur 2) gebildeten, durch das Walzen ebenfalls einen etwa ovalen Querschnitt aufweisenden supraleitenden Filamente (Leiteradern) aus dem HTS-Material mit 16j bezeichnet.

## Patentansprüche

1. Bandförmiger Multifilamentsupraleiter
mit einer Matrix aus normalleitendem Matrixmaterial, das eine vorbestimmte elektrische Leitfähigkeit bei der Betriebstemperatur des Multifilamentsupraleiters besitzt, und
mit mehreren in das Matrixmaterial eingebetteten supraleitenden Filamenten, wobei die Filamente jeweils
ein Supraleitermaterial mit einer metalloxidischen Hoch-Tc-Phase aufweisen und
in der Matrix um die Achse des bandförmigen Multifilamentsupraleiters verdrillt angeordnet sind,
**dadurch gekennzeichnet,**
**daß** die Matrix (3) einen zentralen Kernbereich (13) aus einem Kernmaterial (12') mit einer gegenüber der elektrischen Leitfähigkeit des Matrixmaterials (15) um mindestens eine Größenordnung geringeren elektrischen Leitfähigkeit aufweist.

2. Multifilamentsupraleiter nach Anspruch 1, **dadurch gekennzeichnet, daß** das normalleitende Matrixmaterial (15) aus Ag oder einer Ag-Legierung besteht.

3. Multifilamentsupraleiter nach Anspruch 2, **gekennzeichnet durch** eine Ag-Legierung mit mindestens einer gegenüber dem reinen Ag die elektrische Leitfähigkeit herabsetzenden Legierungskomponente.

4. Multifilamentsupraleiter nach einem der Ansprüche 1 bis 3, **gekennzeichnet durch** ein elektrisch isolierendes Kernmaterial (12').

5. Multifilamentsupraleiter nach einem der Ansprüche 1 bis 4, **gekennzeichnet durch** ein oxidisches Kernmaterial (12').

6. Multifilamentsupraleiter nach Anspruch 5, **dadurch gekennzeichnet, daß** das Kernmaterial (12') aus der Gruppe ZrO₂, SiO₂, CuO₂, Al₂O₃ ausgewählt ist.

7. Multifilamentsupraleiter nach einem der Ansprüche 1 bis 6, **gekennzeichnet durch** ein Kernmaterial (12') auf Basis eines Hoch-T_{c}-Supraleitermaterials, bei dem zur Herabsetzung der supraleitenden Übergangstemperatur unter die Betriebstemperatur die Stöchiometrie gegenüber der supraleitenden Hoch-T_{c}-Phase geändert ist.

8. Multifilamentsupraleiter nach einem der Ansprüche 1 bis 6, **gekennzeichnet durch** ein Kernmaterial (12') auf Basis eines Hoch-T_{c}-Supraleitermaterials, dem zur Herabsetzung der supraleitenden Übergangstemperatur unter die Betriebstemperatur mindestens eine weitere Komponente hinzugefügt ist.

9. Verfahren zur Herstellung des Multifilamentsupraleiters nach einem der Ansprüche 1 bis 8, **dadurch gekennzeichnet, daß** zunächst ein Strangpreßbolzen (7) ausgebildet wird, der eine zentrale Bohrung (8), die mit dem Kernmaterial (12) gefüllt ist, sowie einen diese Bohrung (8) umgebenden Strangpreßkörper (10) aus dem Matrixmaterial (15) mit Bohrungen (9j) enthält, die mit einem Vorprodukt (11j) des Supraleitermaterials gefüllt sind, und daß dann dieser Strangpreßbolzen (7) mehreren Verformungsschritten und Temperaturbehandlungen unterzogen wird, wobei mittels mindestens eines Walzschrittes die Bandform des Endproduktes des Multifilamentsupraleiters (7') erzeugt wird.

## Claims

1. Tape-shaped multifilament superconductor comprising a matrix consisting of normal-conducting matrix material displaying predetermined electrical conductivity at the operating temperature of the multifilament superconductor and a plurality of superconducting filaments embedded in the matrix material, the filaments each comprising a superconducting material with a high T_{c} metal oxide phase and being arranged in the matrix in such a manner that they are twisted around the axis of the tape-shaped multifilament superconductor, **characterised in that** the matrix (3) has a central core region (13) consisting of a core material (12') displaying electrical conductivity at least an order of magnitude lower than the electrical conductivity of the matrix material (15).

2. Multifilament superconductor according to claim 1, **characterised in that** the normal-conducting matrix material (15) consists of Ag or an Ag alloy.

3. Multifilament superconductor according to claim 2, **characterised by** an Ag alloy with at least one alloying component reducing the electrical conductivity compared to pure Ag.

4. Multifilament superconductor according to one of claims 1 to 3, **characterised by** an electrically insulating core material (12').

5. Multifilament superconductor according to one of claims 1 to 4, **characterised by** an oxide core material (12').

6. Multifilament superconductor according to claim 5, **characterised in that** the core material (12') is selected from the group consisting of ZrO₂, SiO₂, CuO₂ and Al₂O₃.

7. Multifilament superconductor according to one of claims 1 to 6, **characterised by** a core material (12') based on a high T_{c} superconducting material in which the stoichiometry is varied compared to the high T_{c} superconducting phase in order to reduce the superconducting transition temperature to below the operating temperature.

8. Multifilament superconductor according to one of claims 1 to 6, **characterised by** a core material (12') based on a high T_{c} superconducting material to which at least one further component is added in order to reduce the superconducting transition temperature to below the operating temperature.

9. Method for the production of the multifilament superconductor according to one of claims 1 to 8, **characterised in that** an extrusion billet (7) is first formed, containing a central bore (8) filled with the core material (12) and an extruded part (10) consisting of the matrix material (15) surrounding this bore (8) and provided with bores (9j) filled with a precursor (11j) of the superconducting material and that this extrusion billet (7) is then subjected to several deformation steps and heat treatment operations, the tape shape of the end product of the multifilament superconductor (7') being produced by means of at least one rolling step.

## Revendications

1. Supraconducteur multibrins en forme de bande comprenant :
- une matrice faite d'un matériau normalement conducteur, qui possède une conductibilité électrique définie à la température de fonctionnement du supraconducteur,
- de filaments supraconducteurs noyés dans le matériau de la matrice, chacun d'eux présentant une phase d'oxyde métallique à haute température et étant monté en torsade autour de l'axe du supraconducteur,
**caractérisé en ce que**
la matrice (3) comporte un noyau central (13) fait d'un matériau (13') dont la conductibilité électrique est, par rapport à celle du matériau constituant la matrice, plus faible d'au moins un ordre de grandeur.

2. Supraconducteur selon la revendication 1,
**caractérisé en ce que**
le matériau normalement conducteur (15) constituant la matrice est de l'argent ou un alliage d'argent.

3. Supraconducteur selon la revendication 2,
**caractérisé en ce que**
l'alliage d'argent comprend au moins un composant qui abaisse sa conductibilité électrique par rapport à celle de l'argent pur.

4. Supraconducteur selon l'une quelconque des revendications 1 à 3,
**caractérisé en ce que**
le matériau (12') du noyau est isolant électriquement.

5. Supraconducteur selon l'une quelconque des revendications 1 à 4,
**caractérisé en ce que**
le matériau (12') du noyau est un oxyde.

6. Supraconducteur selon la revendication 5,
**caractérisé en ce que**
le matériau (12') du noyau est choisi dans le groupe ZrO₂, SiO₂, CuO₂, Al₂O₃.

7. Supraconducteur selon l'une quelconque des revendications 1 à 6,
**caractérisé en ce que**
le matériau (12') du noyau est à base d'un matériau supraconducteur à haute température de changement brusque de conductibilité dans lequel, pour abaisser la température de transition supraconductrice en dessous de la température du fonctionnement, la stoechiométrie par rapport à la phase supraconductrice à haute température est modifiée.

8. Supraconducteur selon l'une quelconque des revendications 1 à 6,
**caractérisé en ce que**
le matériau (12') du noyau est à base d'un matériau supraconducteur auquel a été ajouté un autre composant pour abaisser la température de transition supraconductrice en dessous de la température de fonctionnement.

9. Procédé de fabrication du supraconducteur multibrins selon l'une quelconque des revendications 1 à 8,
**caractérisé en ce qu'**
- on forme d'abord par filage à la presse un boudin (7) présentant un alésage central (8) qui est rempli par le matériau (12) du noyau, qu'entoure le corps filé à la presse (10) fait du matériau de la matrice (15) et percé d'alésages (9j) remplis par un préproduit (11j) du matériau supraconducteur,
- ensuite le boudin filé (7) est soumis à plusieurs opérations de formage et de traitement thermique et, par au moins une opération de roulage il reçoit la forme d'une bande qui est celle à son état final, du supraconducteur multibrins.
